# FASCICULE DE BREVET EUROPEEN

(11) **EP 3 044 025 B1**
(45) Date de publication et mention de la délivrance du brevet: **25.10.2017**
(21) Numéro de dépôt: 14772083.3
(22) Date de dépôt: 10.09.2014
(51) Int. Cl.: G01R 31/00, G01R 31/02, B60L 3/00

(54) **DISPOSITIF DE DÉTECTION D'UN DÉFAUT D'ISOLEMENT DESTINÉ À TESTER UN DÉFAUT D'ISOLEMENT EN CONDITIONS CRITIQUES**
VORRICHTUNG ZUR ERKENNUNG VON ISOLATIONSFEHLERN UND ZUR PRÜFUNG AUF ISOLATIONSFEHLER UNTER KRITISCHEN BEDINGUNGEN
INSULATION FAULT DETECTION DEVICE FOR TESTING FOR INSULATION FAULTS UNDER CRITICAL CONDITIONS

(30) Priorité: 13.09.2013 FR 1358868
(43) Date de publication de la demande: 20.07.2016
(73) Titulaire: Commissariat à l'Energie Atomique et aux Energies Alternatives, 75015 Paris (FR)
(72) Inventeur: CHATROUX, Daniel, F-38470 Têche (FR); CARCOUET, Sébastien, F-38450 Vif (FR)
(74) Mandataire: Guérin, Jean-Philippe
(86) Numéro de dépôt international: PCT/EP2014/069330
(87) Numéro de publication internationale: WO 2015/036456

(56) Documents cités:
- FR-A1- 2 297 427
- FR-A1- 2 976 083
- US-A1- 2010 156 426

## Description

L'invention concerne l'isolement d'une alimentation électrique à tension continue par rapport à la terre, et en particulier la détection d'un défaut d'isolement pour une alimentation électrique de puissance.

Les systèmes électriques de forte puissance à tension continue connaissent un développement important. En effet, de nombreux systèmes de transport incluent une alimentation de tension continue.

Les véhicules hybrides combustion/électrique ou électriques incluent notamment des batteries de forte puissance. Pour obtenir le niveau de tension adéquat, on place en série plusieurs accumulateurs électrochimiques. Pour obtenir de fortes puissances et capacités, on place plusieurs groupes d'accumulateurs en parallèle. Le nombre d'étages (nombre de groupes d'accumulateurs en série) et le nombre d'accumulateurs en parallèle dans chaque étage varient en fonction de la tension, du courant et de la capacité souhaités pour la batterie. L'association de plusieurs accumulateurs est appelée une batterie d'accumulateurs.

Les accumulateurs électrochimiques utilisés pour de tels véhicules sont généralement du type lithium ion pour leur capacité à stocker une énergie importante avec un poids et un volume contenus. Les technologies de batterie de type Lithium ion phosphate de fer LiFePO4 font l'objet d'importants développements du fait d'un niveau de sécurité intrinsèque élevé, au détriment d'une densité de stockage d'énergie un peu en retrait.

De telles batteries sont utilisées pour entraîner un moteur électrique à courant alternatif par l'intermédiaire d'un onduleur. Les niveaux de tension nécessaires pour de tels moteurs atteignent plusieurs centaines de Volts, typiquement de l'ordre de 400 Volts. De telles batteries comportent également une forte capacité afin de favoriser l'autonomie du véhicule en mode électrique.

Le schéma de liaison à la terre d'une batterie de puissance de véhicule automobile est le plus souvent assimilable à un régime de neutre IT d'un réseau électrique, c'est-à-dire un neutre isolé par rapport à la terre et une masse mécanique raccordée à la terre (sauf en roulage où la masse mécanique est isolée de la terre par l'intermédiaire des pneumatiques).

Plusieurs raisons techniques spécifiques à l'application automobile amènent ainsi à l'utilisation d'un isolement entre la masse mécanique du véhicule (formée par le châssis et la carrosserie métalliques du véhicule, et donc accessibles à l'utilisateur) et les potentiels de la batterie. La raison principale est qu'il n'est pas envisageable lors d'un premier défaut d'isolement en roulage de déconnecter instantanément la batterie de traction. Par exemple, dans le cas où l'un des pôles de la batterie est relié à la masse mécanique et que le défaut d'isolement apparaît sur l'autre pôle, ceci se traduit par un court-circuit et la fusion immédiate du fusible de protection. Cela aurait pour effet de rendre le véhicule dangereux, du fait de la disparition de la puissance de traction ou du freinage récupératif. Ceci oblige donc à devoir isoler la batterie et surveiller cet isolement pour des raisons de sécurité des personnes par un contrôleur d'isolement. En effet, si lors d'un premier défaut il n'y a aucun risque pour l'utilisateur, il convient de l'alerter de ce premier défaut avant l'apparition d'un second défaut ayant pour effet de déconnecter la batterie de traction car provoquant un court-circuit entre les bornes positive et négative de la batterie. De plus, lors de ce second défaut, la tension de la batterie serait directement reliée à la masse mécanique du véhicule et l'utilisateur serait donc potentiellement en contact avec celle-ci. Du fait du risque potentiel d'une telle source d'énergie pour les utilisateurs, l'isolement et le contrôle de l'isolement entre la batterie et la masse mécanique doivent être particulièrement soignés. Toute partie du véhicule reliée électriquement à la batterie doit être isolée par rapport aux masses. Cet isolement est réalisé par l'utilisation de matériaux isolants. L'isolement peut se détériorer avec le temps (à cause des vibrations, des chocs mécaniques, de la poussière, etc.), et donc mettre la masse mécanique sous un potentiel dangereux.

Par ailleurs, il peut être envisagé d'utiliser un chargeur non isolé galvaniquement du réseau électrique. La masse mécanique du véhicule étant normativement reliée à la terre lors des recharges et le régime de neutre utilisé classiquement (régime TT) en résidentiel connectant le neutre à la terre, cela revient à connecter pendant les recharges la masse mécanique du véhicule à un des potentiels de la batterie. Pendant ces recharges, la tension complète de la batterie est donc appliquée aux bornes de l'isolement contrairement au cas nominal où seulement la moitié de cette tension est appliquée et surtout contrôlée. Cet isolement pourrait ne pas être capable de tenir la tension complète créant un second défaut instantanément ayant pour conséquence un court-circuit.

Les dispositifs de détection de défaut d'isolement connus sont inadaptés à anticiper une défaillance de l'isolement en présence d'une différence de potentiel entre une borne et la masse supérieure à cette différence de potentiel en fonctionnement normal. Ces dispositifs ne testent donc pas le défaut d'isolement dans ses conditions critiques d'apparition. Par ailleurs, la plupart des dispositifs de détection de défaut d'isolement induisent une consommation électrique non négligeable, avec une conséquence sur l'autonomie du véhicule.

Le document FR2976083 décrit un dispositif d'isolement comprenant un montage en pont avec un interrupteur commandé respectif dans quatre branches, un circuit de détection étant monté dans une cinquième branche en pont. Un circuit de commande maintient les interrupteurs ouverts avec un rapport cyclique, de façon à limiter la consommation de courant.

Le document US2010/156426 décrit un circuit de détection d'un défaut d'isolement entre une source de tension continue et une masse électrique. Un circuit en pont muni d'interrupteurs commandés est connecté d'une part à la masse, et d'autre part séquentiellement à chaque borne d'une source de tension continue.

L'invention vise à résoudre un ou plusieurs de ces inconvénients. L'invention porte ainsi sur un dispositif de détection d'un défaut d'isolement entre une source de tension continue et une masse électrique, tel que défini dans les revendications annexées.

L'invention porte également sur un système tel que défini dans les revendications annexées.

D'autres caractéristiques et avantages de l'invention ressortiront clairement de la description qui en est faite ci-après, à titre indicatif et nullement limitatif, en référence aux dessins annexés, dans lesquels :
- la figure 1 est une représentation schématique d'un exemple de véhicule à moteur électrique alimenté par batterie;
- la figure 2 est une représentation schématique d'un dispositif de détection de défaut d'isolement mis en oeuvre dans un mode de réalisation de l'invention ;
- la figure 3 est un schéma électrique d'un véhicule muni d'un dispositif de détection, en présence d'un type de défaut d'isolement ;
- les figures 4 et 5 illustrent des configurations successives du dispositif de détection de la figure 2 pour un premier type de test ;
- la figure 6 est un diagramme illustrant le courant à travers un condensateur du dispositif de détection ;
- les figures 7 et 8 illustrent des configurations successives du dispositif de détection de la figure 2 pour un deuxième type de test.

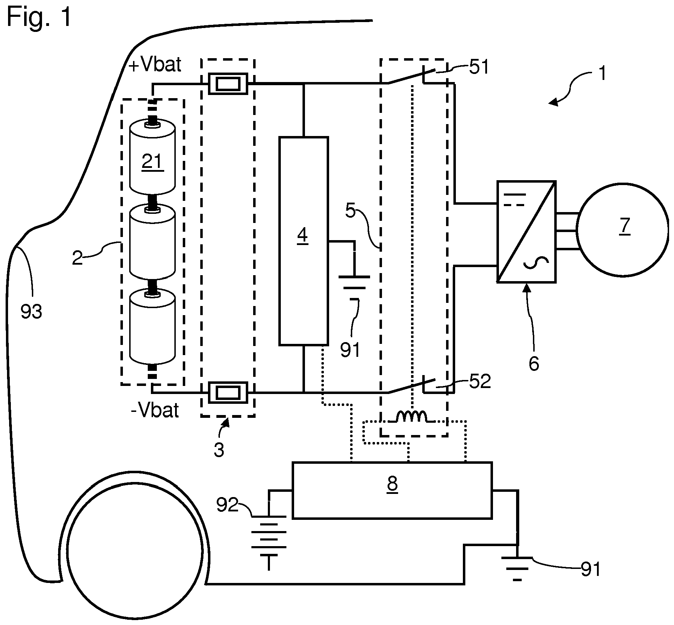

La figure 1 illustre un exemple de véhicule 1 mettant en oeuvre un mode de réalisation de l'invention. Le véhicule 1 est un véhicule électrique comprenant de façon connue en soi une batterie 2 incluant des accumulateurs électrochimiques 21 connectés en série. La batterie 2 comprend un grand nombre d'accumulateurs 21 connectés en série, typiquement entre 40 et 150 accumulateurs en fonction de la tension nécessaire et du type d'accumulateurs utilisé. La tension aux bornes de la batterie 2 chargée est typiquement de l'ordre de 400 V. La batterie 2 applique une tension +Vbat sur une première borne, et une tension -Vbat sur une deuxième borne. Les accumulateurs 21 sont connectés en série par l'intermédiaire de connexions électriques de puissance. Les bornes de la batterie 2 sont connectées à une interface continu d'un onduleur 6. Un moteur électrique 7 est connecté sur une interface alternatif de l'onduleur 6.

La connexion entre les bornes de la batterie 2 et l'interface continu de l'onduleur 6 est réalisée par l'intermédiaire d'un circuit de protection 3 et par l'intermédiaire d'un circuit d'accouplement de puissance 5. Le circuit de protection 3 peut comprendre de façon connue en soi des fusibles configurés pour ouvrir la connexion lors d'un court-circuit. Le circuit d'accouplement de puissance 5 comprend des interrupteurs 51 et 52 permettant de connecter/déconnecter sélectivement les bornes de la batterie 2 à l'interface continu de l'onduleur 6. L'ouverture/fermeture des interrupteurs 51 et 52 est commandée par un circuit de commande 8, typiquement un calculateur de supervision du fonctionnement de la batterie 2. Le circuit de commande 8 est typiquement alimenté par l'intermédiaire d'une batterie 92 d'alimentation du réseau de bord du véhicule 1, présentant un niveau de tension très inférieur à celui de la batterie 2. Le circuit de commande 8 est typiquement connecté à la masse mécanique 91, incluant le châssis et la carrosserie 93 métalliques du véhicule 1. Un dispositif de détection d'un défaut d'isolement 4 est connecté aux bornes de la batterie 2 et à la masse mécanique 91.

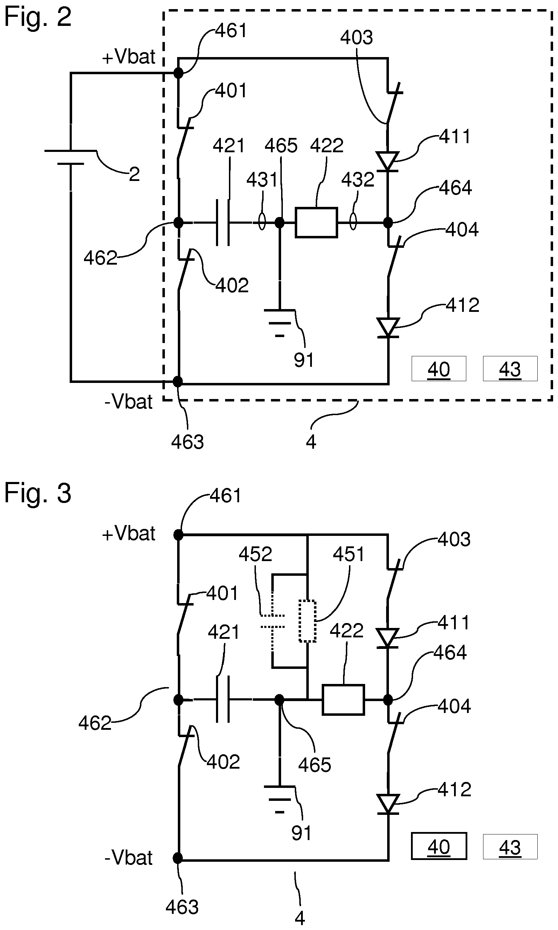

La figure 2 est une représentation schématique d'un exemple de dispositif de détection de défaut d'isolement 4 selon un mode de réalisation de l'invention, accolé à la batterie 2. Le dispositif de détection de défaut d'isolement 4 comprend un montage en pont présentant des premier à quatrième noeuds 461 à 464. Une première branche raccorde électriquement les noeuds 461 et 462 et comprend un premier interrupteur commandé 401. Une deuxième branche raccorde électriquement les noeuds 462 et 463 et comprend un deuxième interrupteur commandé 402. Une troisième branche raccorde électriquement les noeuds 461 et 464 et comprend un troisième interrupteur 403. Ce troisième interrupteur 403 est avantageusement connecté en série avec un premier élément à conduction unidirectionnelle 411. Une quatrième branche raccorde électriquement les noeuds 464 et 463 et comprend un quatrième interrupteur 404. Ce quatrième interrupteur 404 est avantageusement connecté en série avec un deuxième élément à conduction unidirectionnelle 412. Une cinquième branche raccorde électriquement les noeuds 462 et 464. Un condensateur 421 et une charge résistive 422 sont connectés entre les noeuds 462 et 464 dans la cinquième branche. Un noeud intermédiaire 465 entre le condensateur 421 et la charge résistive 422 est connecté au potentiel de la masse mécanique 91. Un capteur de courant 431 mesure avantageusement le courant traversant le condensateur 421. Un capteur de courant 432 mesure avantageusement le courant traversant la charge résistive 422. Le dispositif de détection de défaut d'isolement 4 comprend un circuit de détection 43. Le circuit de détection 43 détermine un défaut d'isolement et éventuellement son amplitude en fonction de mesures.

Le potentiel +Vbat de la batterie 2 est appliqué sur le noeud 461. Le potentiel -Vbat de la batterie 2 est appliqué sur le noeud 463. Les interrupteurs commandés 401 à 404 sont configurés pour interrompre sélectivement la conduction dans leur branche respective. L'ouverture et la fermeture des interrupteurs 401 à 404 est pilotée par un circuit de commande 40. Les interrupteurs commandés 401 à 404 sont par exemple des transistors à effet de champs dont la grille est pilotée par le circuit de commande 40. Des exemples de mode de commande d'interrupteurs 401 à 404 par le circuit de commande 40 seront détaillés par la suite. L'élément de conduction unidirectionnelle 411 permet uniquement une conduction du noeud 461 vers le noeud 464. L'élément de conduction unidirectionnelle 412 permet uniquement une conduction du noeud 464 vers le noeud 463. Les éléments de conduction unidirectionnelle 411 et 412 sont en l'occurrence des diodes. Par l'intermédiaire de l'interrupteur 403, l'anode de la diode 411 est connectée au noeud 461 et la cathode de la diode 411 est connectée au noeud 464. Par l'intermédiaire de l'interrupteur 404, l'anode de la diode 412 est connectée au noeud 464 et la cathode de la diode 412 est connectée au noeud 463.

La figure 3 est un schéma électrique d'un véhicule muni d'un dispositif de détection 4 en présence d'un exemple de défaut d'isolement entre la masse mécanique 91 et la borne positive de la batterie 2. La résistance 451 connectée entre le noeud 461 et le noeud 465 est représentative d'une résistance de défaut d'isolement entre la borne positive de la batterie 2 et la masse mécanique 91. Le condensateur 452 connecté entre le noeud 461 et le noeud 465 en parallèle de la résistance 451 est représentatif soit des capacités parasites entre la borne positive de la batterie 2 et la masse 91, soit représentative de capacités d'antiparasitage du véhicule, soit représentative d'une combinaison des 2.

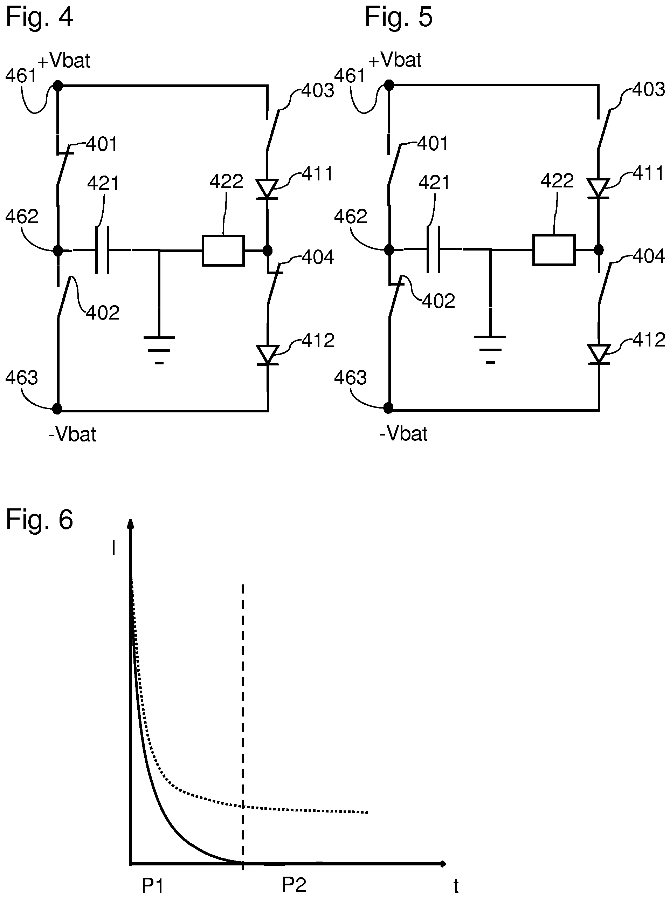

Les figures 4 et 5 illustrent des configurations successives des interrupteurs du montage en pont du dispositif de détection de défaut d'isolement 4 lors d'un test de défaut d'isolement par rapport à la borne positive de la batterie 2.

Initialement, en l'absence de test de défaut d'isolement, le circuit de commande 40 maintient l'ensemble d'interrupteurs 401 à 404 simultanément ouverts, de façon à éliminer la consommation électrique du dispositif de détection 4. Avantageusement, les interrupteurs 401 à 404 seront maintenus simultanément ouverts avec un rapport cyclique au moins égal à 98 %, et de préférence au moins égal à 99 %.

À la figure 4, on initie un test de défaut d'isolement entre la borne positive de la batterie 2 et la masse mécanique 91. Le condensateur 421 est supposé initialement déchargé. Le circuit de commande 40 ferme alors les interrupteurs 401 et 404 et maintient les interrupteurs 402 et 403 ouverts durant une première étape. La différence de potentiel aux bornes de la batterie 2 est appliquée aux bornes de la cinquième branche (à des chutes de tension près à l'intérieur des interrupteurs 401 et 404). Durant cette première étape, le condensateur 421 se charge, un courant de charge étant fourni par la batterie 2 et traversant les interrupteurs 401 et 404. Avantageusement, cette première étape présente une durée suffisante pour que la différence de potentiel Vc aux bornes du condensateur 421 atteigne au moins une valeur E/2, avec E la différence de potentiel aux bornes de la batterie 2. De préférence, cette première étape présente une durée suffisante pour que la différence de potentiel aux bornes du condensateur 421 atteigne au moins la valeur 0,9 ∗ E, voire E.

À l'issue de cette première étape de charge du condensateur 421, le circuit de commande 40 initie une deuxième étape de test du défaut d'isolement entre la borne positive de la batterie 2 et la masse 91. Le circuit de commande 40 ferme alors l'interrupteur 402 et maintient les interrupteurs 401, 403 et 404 ouverts. Le condensateur 421 et la batterie 2 sont alors connectés en série entre le noeud 461 et la masse (noeud 465) de sorte que la différence de potentiel entre les noeuds 461 et 465 correspond à la somme algébrique de E (la différence de potentiel aux bornes de la batterie 2) et Vc (la différence de potentiel aux bornes du condensateur 421). Une différence de potentiel Vc+E est ainsi appliquée entre la masse 91 et le noeud 461.

En présence d'une résistance 451 de défaut d'isolement ou du condensateur 452, ceux-ci permettent de former un circuit de décharge du condensateur 421 entre le noeud 461 et le noeud 465. Le diagramme de la figure 6 illustre le courant traversant le condensateur 421 durant cette deuxième étape. On prendra ici comme hypothèse, que le condensateur 421 présente une capacité très supérieure à celle du condensateur 452, typiquement au moins quatre fois supérieure. Durant une première phase P1, le condensateur 452 se charge et son influence est prépondérante sur la forme de la courbe de décharge du condensateur 421, alors que le courant à travers la résistance de défaut d'isolement est négligeable. Le courant de décharge du condensateur 421 décroît exponentiellement, la charge transférée pendant cette phase étant proportionnelle à la valeur de capacité du condensateur 452. Dans une deuxième phase P2, le courant de décharge du condensateur 421 se stabilise à une valeur quasi-constante, du fait d'une décharge exponentielle avec une constante de temps très supérieure à une durée de mesure. Cette valeur stabilisée définit la valeur de la résistance de défaut d'isolement 451. En l'absence de résistance de défaut d'isolement 451, le courant de décharge devient nul dans la phase P2 (courbe en pointillés). La stabilisation du courant de décharge est bien entendu une approximation en supposant que le condensateur 421 a une capacité infinie.

Selon une première variante, en poursuivant la décharge du condensateur 421 durant la phase P2, le circuit 43 peut déterminer la présence d'une résistance de défaut d'isolement et son amplitude, à partir d'une mesure de courant traversant le condensateur 421 (par l'intermédiaire du capteur 431) à un instant donné après la fermeture de l'interrupteur 402. Cette résistance de défaut d'isolement est alors proportionnelle au courant de décharge stabilisé du condensateur 421 durant la phase P2. En fonction de la tension aux bornes du condensateur 421 à un instant donné durant la phase P1, il est également possible de déterminer la valeur de capacité du condensateur 452. En effet, on peut considérer que la décharge du condensateur 421 durant la phase P1 assure essentiellement la charge du condensateur 452.

Selon une deuxième variante, on détermine la valeur de la capacité du condensateur 452 en mesurant la charge résiduelle du condensateur 421. A la fin de la phase P1, le courant de décharge du condensateur 451 reste représentatif de la résistance de défaut d'isolement. Pour mesurer la capacité du condensateur 452, le circuit de commande 40 ferme les interrupteurs 402 et 403 et ouvre les interrupteurs 401 et 404 à la fin de la phase P1. Par une mesure du courant (mesuré par le capteur 432) traversant la charge résistive 422 (dont la valeur de résistance sera alors calibrée), le circuit 43 détermine la charge résiduelle dans le condensateur 421. Cette configuration des interrupteurs 402 et 403 permet par ailleurs de décharger le condensateur 421 pour une étape ultérieure de test, par exemple pour le test de l'autre polarité de la batterie. En outre, la charge résiduelle du condensateur 421 est alors au moins partiellement récupérée par la batterie 2 durant cette décharge.

Les première et deuxième variantes peuvent toutes deux être mises en oeuvre par le dispositif de détection 4, par exemple dans un souci de redondance.

La détermination de la capacité du condensateur 452 permet par exemple de déterminer l'amplitude des capacités parasites, ou de déterminer le vieillissement d'un condensateur d'antiparasitage.

L'invention permet ainsi de réaliser une détection de défaut d'isolement :
- avec un potentiel élevé entre une borne de la batterie 2 et la masse 91 quel que soit le niveau de charge de la batterie ;
- avec un potentiel supérieur à la tension nominale de la batterie, au moyen d'une structure simple ;
- avec une consommation électrique extrêmement réduite.

Dans l'exemple détaillé précédemment, la charge résistive a également pour fonction de limiter le courant de charge du condensateur 421 durant la première étape. Cette limitation permet notamment de protéger la batterie 2.

Les éléments de conduction unidirectionnelles 411 et 412 servent à empêcher la circulation d'un courant dans les diodes parasites des interrupteurs 403 et 404 respectivement, lorsque ceux-ci sont inaptes à supporter une tension inverse (par exemple pour des interrupteurs 403 et 404 sous forme de transistors MOSFET).

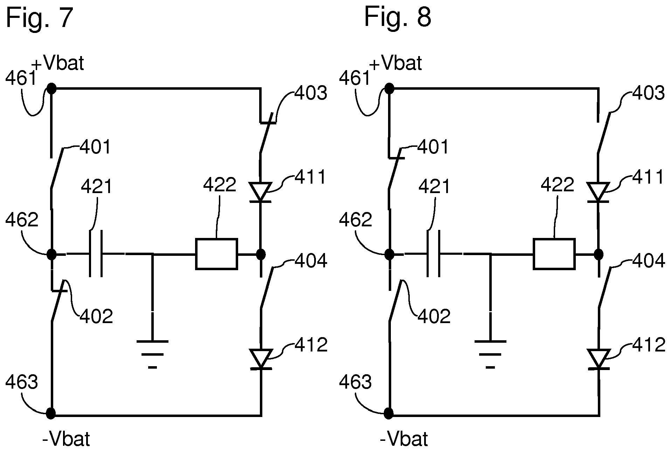

Les figures 7 et 8 illustrent des configurations successives des interrupteurs du montage en pont du dispositif de détection de défaut d'isolement 4 lors d'un test de défaut d'isolement par rapport à la borne négative de la batterie 2.

À la figure 7, on initie le test de défaut d'isolement entre la borne négative de la batterie 2 et la masse mécanique 91. Le condensateur 421 est supposé initialement déchargé. Le circuit de commande 40 ferme alors les interrupteurs 402 et 403 et maintient les interrupteurs 401 et 404 ouverts durant une première étape. La différence de potentiel aux bornes de la batterie 2 est appliquée aux bornes de la cinquième branche. Durant cette première étape, le condensateur 421 se charge, un courant de charge étant fourni par la batterie 2 et traversant les interrupteurs 402 et 403.

À l'issue de cette première étape de charge du condensateur 421, le circuit de commande 40 initie une deuxième étape de test du défaut d'isolement entre la borne négative de la batterie 2 et la masse 91. Le circuit de commande 40 ferme alors l'interrupteur 401 et maintient les interrupteurs 402, 403 et 404 ouverts. Le condensateur 421 et la batterie 2 sont alors connectés en série entre le noeud 463 et la masse (noeud 465) de sorte que la différence de potentiel entre les noeuds 463 et 465 correspond à la somme algébrique de la différence de potentiel E aux bornes de la batterie 2 et de la différence de potentiel Vc aux bornes du condensateur 421. Une différence de potentiel Vc+E est ainsi appliquée entre la masse 91 et le noeud 463.

Les stratégies selon les première et deuxième variantes décrites auparavant peuvent aussi être utilisées pour la mesure de défaut d'isolement et/ou de la capacité du condensateur 452 entre la borne négative de la batterie 2 et la masse 91.

En fonctionnement, le condensateur 421, les éléments de conduction unidirectionnels 411 et 412, et les interrupteurs 401 et 402 sont soumis à une différence de potentiel d'une valeur de E. La charge résistive 422 et les interrupteurs 403 et 404 sont soumis à une différence de potentiel d'une valeur de 2∗E. L'homme du métier pourra réaliser un dimensionnement de ces composants en conséquence. La charge résistive 422 pourra avantageusement présenter une résistance au moins égale à 100 kΩ. La charge résistive 422 illustrée dans les différentes variantes permet de réduire l'amplitude du courant traversant le condensateur 421. Cependant, l'invention peut également être mise en oeuvre sans une telle charge.

Pour un véhicule automobile, les tests de défaut d'isolement peuvent être réalisés de façon périodique ou ponctuelle, durant le roulage ou à l'arrêt du véhicule.

## Revendications

1. Dispositif de détection d'un défaut d'isolement (4) entre une source de tension continue et une masse électrique, comprenant :
- un montage en pont comprenant :
- des premier à quatrième noeuds (461,462,463,464), les premier et troisième noeuds étant destinés à être connectés aux bornes d'une source de tension continue de puissance ;
- une première branche raccordant les premier et deuxième noeuds, et comprenant un premier interrupteur commandé (401) configuré pour interrompre sélectivement la conduction dans la première branche ;
- une deuxième branche raccordant les deuxième et troisième noeuds, et comprenant un deuxième interrupteur commandé (402) configuré pour interrompre sélectivement la conduction dans la deuxième branche ;
- une troisième branche raccordant les premier et quatrième noeuds, et comprenant un troisième interrupteur commandé (403) configuré pour interrompre sélectivement la conduction dans la troisième branche ;
- une quatrième branche raccordant les troisième et quatrième noeuds et comprenant un quatrième interrupteur commandé (404) configuré pour interrompre sélectivement la conduction dans la quatrième branche;
- une cinquième branche raccordant les deuxième et quatrième noeuds,
**Caractérisé en ce que** :
- la cinquième branche comprenant un condensateur (421) connecté entre les deuxième et quatrième noeuds, une masse électrique (491) étant connectée à la cinquième branche entre ledit condensateur et le quatrième noeud;
- un circuit de commande (40) commandant lesdits interrupteurs de façon à réaliser les étapes successives de :
a) maintenir les premier et quatrième interrupteurs fermés et les deuxième et troisième interrupteurs ouverts, de façon à charger ledit condensateur ;
b) maintenir le deuxième interrupteur fermé et les premier, troisième et quatrième interrupteurs ouverts ;
- un premier circuit de mesure (431) mesurant le courant traversant ledit condensateur (421) ;
- un circuit d'analyse (43) déterminant l'amplitude d'un défaut d'isolement en fonction d'un courant mesuré par le circuit de mesure durant l'étape b).

2. Dispositif de détection de défaut d'isolement selon la revendication 1, dans lequel la cinquième branche comprend en outre une charge résistive (422) connectée entre le potentiel de masse et le quatrième noeud (464).

3. Dispositif de détection de défaut d'isolement selon la revendication 1 ou 2, comprenant en outre un circuit de détermination (43) de la charge résiduelle dudit condensateur après l'étape b), ledit circuit d'analyse déterminant une valeur de capacité entre le premier noeud (461) et la masse électrique en fonction de la charge résiduelle déterminée.

4. Dispositif de détection de défaut d'isolement selon les revendications 2 et 3, comprenant en outre un deuxième circuit de mesure (432) mesurant le courant traversant ladite charge résistive (422), et dans lequel ledit circuit de commande (40) commande lesdits interrupteurs de façon à réaliser une étape c) à l'issue de l'étape b), l'étape c) incluant le maintien des deuxième et troisième interrupteurs fermés et des premier et quatrième interrupteurs ouverts, ledit circuit de détermination de la charge résiduelle (43) déterminant la charge résiduelle dudit condensateur en fonction du courant mesuré à travers le deuxième circuit de mesure durant l'étape c).

5. Dispositif de détection de défaut d'isolement selon l'une quelconque des revendications précédentes, dans lequel ledit circuit de commande (40) commande en outre lesdits interrupteurs de façon à réaliser des étapes successives de :
d) maintenir les deuxième et troisième interrupteurs fermés et les premier et quatrième interrupteurs ouverts, de façon à charger ledit condensateur ;
e) maintenir le premier interrupteur fermé et les deuxième, troisième et quatrième interrupteurs ouverts ;
le circuit d'analyse (43) étant en outre configuré pour déterminer l'amplitude d'un défaut d'isolement en fonction du courant mesuré par le circuit de mesure durant l'étape e).

6. Dispositif de détection de défaut d'isolement selon l'une quelconque des revendications précédentes, dans lequel :
- la troisième branche comprend en outre un premier élément à conduction unidirectionnelle (411) du premier noeud vers le quatrième noeud et connecté en série avec le troisième interrupteur (403) ;
- la quatrième branche comprend en outre un deuxième élément à conduction unidirectionnelle (412) du quatrième noeud vers le troisième noeud et connecté en série avec le quatrième interrupteur (404).

7. Dispositif de détection de défaut d'isolement selon l'une quelconque des revendications précédentes, dans lequel lesdits troisième et quatrième interrupteurs sont des transistors de type MOSFET.

8. Dispositif de détection de défaut d'isolement selon l'une quelconque des revendications précédentes, dans lequel ledit circuit de commande est configuré pour maintenir lesdits premier à quatrième interrupteurs (401, 402, 403, 404) simultanément ouverts avec un rapport cyclique au moins égal à 98 %.

9. Système comprenant :
- une source de tension continue (2) de puissance ;
- un dispositif de détection de défaut d'isolement (4) selon l'une quelconque des revendications précédentes dont les premier et troisième noeuds sont connectés aux bornes de ladite source de tension continue de puissance, ladite masse électrique étant isolée par rapport aux bornes de ladite source de tension continue.

10. Système selon la revendication 9, dans lequel ledit circuit de commande (40) est configuré pour mettre en oeuvre l'étape a) pendant une durée suffisante pour que la tension aux bornes dudit condensateur chargé à l'issue de l'étape a) soit au moins égale à 0,5 ∗ E, avec E la tension aux bornes de ladite source de tension continue.

## Patentansprüche

1. Vorrichtung zur Erfassung eines Isolationsfehlers (4) zwischen einer Gleichspannungsquelle und einer elektrischen Masse, die enthält:
- eine Brückenschaltung, die enthält:
- erste bis vierte Knoten (461, 462, 463, 464), wobei der erste und der dritte Knoten dazu bestimmt sind, mit den Klemmen einer Leistungs-Gleichspannungsquelle verbunden zu werden;
- einen ersten Zweig, der den ersten und den zweiten Knoten miteinander verbindet und einen ersten gesteuerten Schalter (401) enthält, der konfiguriert ist, die Leitung im ersten Zweig selektiv zu unterbrechen;
- einen zweiten Zweig, der den zweiten und den dritten Knoten miteinander verbindet und einen zweiten gesteuerten Schalter (402) enthält, der konfiguriert ist, die Leitung im zweiten Zweig selektiv zu unterbrechen;
- einen dritten Zweig, der den ersten und den vierten Knoten miteinander verbindet und einen dritten gesteuerten Schalter (403) enthält, der konfiguriert ist, die Leitung im dritten Zweig selektiv zu unterbrechen;
- einen vierten Zweig, der den dritten und den vierten Knoten miteinander verbindet und einen vierten gesteuerten Schalter (404) enthält, der konfiguriert ist, die Leitung im vierten Zweig selektiv zu unterbrechen;
- einen fünften Zweig, der den zweiten und den vierten Knoten miteinander verbindet,
**dadurch gekennzeichnet, dass**:
- der fünfte Zweig einen Kondensator (421) enthält, der zwischen dem zweiten und dem vierten Knoten verbunden ist, wobei eine elektrische Masse (491) zwischen dem Kondensator und dem vierten Knoten mit dem fünften Zweig verbunden ist;
- ein Steuerschaltkreis (40) die Schalter so steuert, dass die aufeinanderfolgenden Schritte durchgeführt werden:
a) Geschlossenhalten des ersten und des vierten Schalters und Offenhalten des zweiten und des dritten Schalters, um den Kondensator zu laden;
b) Geschlossenhalten des zweiten Schalters und Offenhalten des ersten, dritten und vierten Schalters;
- ein erster Messschaltkreis (431) den durch den Kondensator (421) fließenden Strom misst;
- ein Analyseschaltkreis (43) die Amplitude eines Isolationsfehlers abhängig von einem vom Messschaltkreis während des Schritts b) gemessenen Strom bestimmt.

2. Vorrichtung zur Erfassung eines Isolationsfehlers nach Anspruch 1, wobei der fünfte Zweig außerdem eine Ohm'sche Last (422) enthält, die zwischen dem Massepotential und dem vierten Knoten (464) verbunden ist.

3. Vorrichtung zur Erfassung eines Isolationsfehlers nach Anspruch 1 oder 2, die außerdem einen Bestimmungsschaltkreis (43) der Restladung des Kondensators nach dem Schritt b) enthält, wobei der Analyseschaltkreis einen Kapazitätswert zwischen dem ersten Knoten (461) und der elektrischen Masse abhängig von der bestimmten Restladung bestimmt.

4. Vorrichtung zur Erfassung eines Isolationsfehlers nach den Ansprüchen 2 und 3, die außerdem einen zweiten Messschaltkreis (432) enthält, der den durch die Ohm'sche Last (422) fließenden Strom misst, und wobei der Steuerschaltkreis (40) die Schalter so steuert, dass ein Schritt c) nach dem Schritt b) durchgeführt wird, wobei der Schritt c) das Geschlossenhalten des zweiten und dritten Schalters und das Offenhalten des ersten und vierten Schalters umfasst, wobei der Bestimmungsschaltkreis der Restladung (43) die Restladung des Kondensators abhängig vom durch den zweiten Messschaltkreis während des Schritts c) gemessenen Stroms bestimmt.

5. Vorrichtung zur Erfassung eines Isolationsfehlers nach einem der vorhergehenden Ansprüche, wobei der Steuerschaltkreis (40) außerdem die Schalter so steuert, dass aufeinanderfolgende Schritte durchgeführt werden:
d) Geschlossenhalten des zweiten und dritten Schalters und Offenhalten des ersten und vierten Schalters, um den Kondensator zu laden;
e) Geschlossenhalten des ersten Schalters und Offenhalten des zweiten, dritten und vierten Schalters;
wobei der Analyseschaltkreis (43) außerdem konfiguriert ist, die Amplitude eines Isolationsfehlers abhängig vom vom Messschaltkreis während des Schritts e) gemessenen Strom zu bestimmen.

6. Vorrichtung zur Erfassung eines Isolationsfehlers nach einem der vorhergehenden Ansprüche, wobei:
- der dritte Zweig außerdem ein erstes Element mit Einwegleitung (411) vom ersten Knoten zum vierten Knoten und mit dem dritten Schalter (403) in Reihe geschaltet enthält;
- der vierte Zweig außerdem ein zweites Element mit Einwegleitung (412) vom vierten Knoten zum dritten Knoten und mit dem vierten Schalter (404) in Reihe geschaltet enthält.

7. Vorrichtung zur Erfassung eines Isolationsfehlers nach einem der vorhergehenden Ansprüche, wobei der dritte und der vierte Schalter MOSFET-Transistoren sind.

8. Vorrichtung zur Erfassung eines Isolationsfehlers nach einem der vorhergehenden Ansprüche, wobei der Steuerschaltkreis konfiguriert ist, den ersten bis vierten Schalter (401, 402, 403, 404) gleichzeitig offen zu halten, mit einem Tastverhältnis mindestens gleich 98%.

9. System, das enthält:
- eine Leistungs-Gleichspannungsquelle (2);
- eine Vorrichtung zur Erfassung eines Isolationsfehlers (4) nach einem der vorhergehenden Ansprüche, von der der erste und der dritte Knoten mit den Klemmen der Leistungs-Gleichspannungsquelle verbunden sind, wobei die elektrische Masse bezüglich der Klemmen der Gleichspannungsquelle isoliert ist.

10. System nach Anspruch 9, wobei der Steuerschaltkreis (40) konfiguriert ist, den Schritt a) während einer ausreichenden Dauer durchzuführen, damit die Spannung an den Klemmen des geladenen Kondensators am Ende des Schritts a) mindestens gleich 0,5 ∗ E ist, mit E der Spannung an den Klemmen der Gleichspannungsquelle.

## Claims

1. Device for detecting an insulation fault (4) between a source of DC voltage and an electrical ground, comprising:
- a bridge configuration comprising:
- first to fourth nodes (461,462,463,464), the first and third nodes being intended to be connected to the terminals of a high-power source of DC voltage;
- a first branch connecting the first and second nodes, and comprising a first controlled switch (401) configured for selectively interrupting the conduction in the first branch;
- a second branch connecting the second and third nodes, and comprising a second controlled switch (402) configured for selectively interrupting the conduction in the second branch;
- a third branch connecting the first and fourth nodes, and comprising a third controlled switch (403) configured for selectively interrupting the conduction in the third branch;
- a fourth branch connecting the third and fourth nodes and comprising a fourth controlled switch (404) configured for selectively interrupting the conduction in the fourth branch;
- a fifth branch connecting the second and fourth nodes,
**characterized in that**:
- the fifth branch comprising a capacitor (421) connected between the second and fourth nodes, an electrical ground (491) being connected to the fifth branch between said capacitor and the fourth node;
- a control circuit (40) controlling said switches in such a manner as to carry out the successive steps for:
a) maintaining the first and fourth switches closed and the second and third switches open, so as to charge said capacitor;
b) maintaining the second switch closed and the first, third and fourth switches open;
- a first measurement circuit (431) measuring the current flowing through said capacitor (421);
- an analyzer circuit (43) determining the amplitude of an insulation fault as a function of a current measured by the measurement circuit during the step b).

2. Insulation fault detection device according to Claim 1, **characterized in that** the fifth branch furthermore comprises a resistive load (422) connected between ground potential and the fourth node (464).

3. Insulation fault detection device according to either of Claims 1 and 2, furthermore comprising a circuit (43) for determining the residual charge in said capacitor after the step b), said analyzer circuit determining a value of capacitance between the first node (461) and the electrical ground as a function of the determined residual charge.

4. Insulation fault detection device according to Claims 2 and 3, furthermore comprising a second measurement circuit (432) measuring the current flowing through said resistive load (422), and **characterized in that** said control circuit (40) controls said switches in such a manner as to carry out a step c) following the step b), the step c) including maintaining the second and third switches closed and the first and fourth switches open, said circuit for determining the residual charge (43) determining the residual charge in said capacitor as a function of the current measured through the second measurement circuit during the step c).

5. Insulation fault detection device according to any one of the preceding claims, **characterized in that** said control circuit (40) furthermore controls said switches in such a manner as to carry out successive steps for:
d) maintaining the second and third switches closed and the first and fourth switches open, so as to charge said capacitor;
e) maintaining the first switch closed and the second, third and fourth switches open;
the analyzer circuit (43) being furthermore configured for determining the amplitude of an insulation fault as a function of the current measured by the measurement circuit during the step e).

6. Insulation fault detection device according to any one of the preceding claims, **characterized in that**:
- the third branch furthermore comprises a first element with unidirectional conduction (411) from the first node toward the fourth node and connected in series with the third switch (403);
- the fourth branch furthermore comprises a second element with unidirectional conduction (412) from the fourth node toward the third node and connected in series with the fourth switch (404).

7. Insulation fault detection device according to any one of the preceding claims, **characterized in that** said third and fourth switches are transistors of the MOSFET type.

8. Insulation fault detection device according to any one of the preceding claims, **characterized in that** said control circuit is configured for maintaining said first to fourth switches (401, 402, 403, 404) simultaneously open with a duty cycle equal to at least 98 %.

9. System comprising:
- a high-power source of DC voltage (2);
- an insulation fault detection device (4) according to any one of the preceding claims whose first and third nodes are connected to the terminals of said high-power source of DC voltage, said electrical ground being insulated with respect to the terminals of said source of DC voltage.

10. System according to Claim 9, **characterized in that** said control circuit (40) is configured for implementing the step a) for a period of time that is sufficiently long for the voltage across the terminals of said capacitor charged after the step a) is equal to at least 0.5 * E, with E being the voltage across the terminals of said source of DC voltage.
